# EUROPEAN PATENT SPECIFICATION

(11) **EP 4 585 940 B1**
(45) Date of publication and mention of the grant of the patent: **28.10.2026**
(21) Application number: 23863351.5
(22) Date of filing: 01.08.2023
(51) Int. Cl.: G01R 31/367, G01R 31/36, G01R 31/392, G01R 31/3842, G01R 31/389, G01R 31/396, G06N 3/08

(54) **ELECTRONIC DEVICE FOR DETECTING BATTERY ABNORMALITY, AND METHOD FOR OPERATING SAME**
ELEKTRONISCHE VORRICHTUNG ZUR ERKENNUNG VON BATTERIEANOMALIEN UND VERFAHREN ZUM BETRIEB DAVON
DISPOSITIF ÉLECTRONIQUE DE DÉTECTION D'ANOMALIE DE BATTERIE ET SON PROCÉDÉ DE FONCTIONNEMENT

(30) Priority: 06.09.2022 KR 20220113110
(43) Date of publication of application: 16.07.2025
(73) Proprietor: LG Energy Solution, Ltd., Seoul 07335 (KR)
(72) Inventor: CHOI, Sung Wook, Daejeon 34122 (KR); LEE, Hyun Jun, Daejeon 34122 (KR); KIM, Geum Bee, Daejeon 34122 (KR); SHIN, Jae Wook, Daejeon 34122 (KR)
(74) Representative: Goddar, Heinz J.
(86) International application number: PCT/KR2023/011213
(87) International publication number: WO 2024/053870

(56) References cited:
- WO-A1-2022/019607
- CN-A- 112 526 376
- CN-A- 114 566 994
- CN-A- 114 942 386
- KR-A- 20200 102 923
- KR-A- 20210 000 206
- KR-A- 20220 016 799
- US-A1- 2021 132 151
- YIN HAO ET AL: "Voltage Fault Diagnosis of Power Batteries based on Boxplots and Gini Impurity for Electric Vehicles", 2019 ELECTRIC VEHICLES INTERNATIONAL CONFERENCE (EV), IEEE, 3 October 2019 (2019-10-03), pages 1 - 5, XP033649594, DOI: 10.1109/EV.2019.8892849

## Description

### [TECHNICAL FIELD]

### CROSS-REFERENCE TO RELATED APPLICATION

This application claims priority to and the benefit of Korean Patent Application No. 10-2022-0113110 filed in the Korean Intellectual Property Office on September 6, 2022.

### TECHNICAL FIELD

Embodiments disclosed herein relate to an electronic device for detecting abnormality of a battery and an operating method of the electronic device.

### [BACKGROUND ART]

Secondary batteries, which are easy to apply depending on a product group and have electrical characteristics such as high energy density, are generally used not only in portable devices but also in electric vehicles (EV), hybrid electric vehicles (HEV), etc., driven by an electrical drive source.

Types of secondary batteries widely used at the present time include lithium ion batteries, lithium polymer batteries, nickel cadmium batteries, nickel hydrogen batteries, nickel zinc batteries, and so forth. An operating voltage of a unit secondary battery cell, i.e., a unit battery cell, is about 2.5 to 4.5 volts (V). Therefore, when a higher output voltage is required, a battery pack is formed by connecting a plurality of battery cells in series. In addition, a battery pack may be constructed by connecting multiple battery cells in parallel depending on a charge/discharge capacity required for the battery pack. Thus, the number of battery cells included in the battery pack may be set variously depending on a required output voltage or charge/discharge capacity.

CN 112526376 A discloses an automobile battery monomer abnormality estimation method and device. The method comprises the following steps: monitoring and extracting battery use data when an automobile is started and shut down in real time; calculating a polarization voltage value of any battery monomer; calculating and analyzing a polarization voltage Z score value of each battery monomer, an accumulated deviation value of the polarization voltage of each battery monomer and a cosine set variance value of an included angle between any two battery monomers by using a Z score model, a statistical model and an angle variance model; carrying out big data model training to obtain a relationship between a battery health state and abnormal quantification, and establishing a battery health state diagnosis database; and judging whether the battery reaches a preset condition of a battery health state diagnosis database or not according to three values so as to obtain a battery diagnosis result. According to the disclosure, the abnormal problem of the power battery system can be found in advance, early warning can be given, and accidents such as fire and explosion of an electric automobile can be reduced.

CN 114566994 A discloses of battery energy storage and a battery performance detection method thereof. The battery energy storage system is formed from inside to outside: a plurality of battery cells form battery boxes, a plurality of battery boxes form battery clusters, a plurality of battery clusters form a battery stack, and the battery stack, a PCS system and an EMS system form the energy storage system; carrying out standard score analysis on the test data of the single cells in the group/cluster, carrying out distribution statistics on the standard score of each single cell, and carrying out statistical analysis detection on the standard scores according to different section numbers; the possible degradation trend of the battery is obtained by calculating the relation between the voltage and time of the single battery, the obvious degradation trend of the battery cell can be seen by drawing the numerical value of the single battery cell in the graph according to the time, and the degradation speed can be calculated. The method has the advantages that the whole battery is diagnosed in real time, battery cell faults are found in advance, the system safety is improved, fault modules and fault monomers are positioned, and other degradation processes are tracked.

CN 114942386 A discloses a power battery fault online detection method and system. The method specifically comprises the steps of setting the length of a sliding window and obtaining battery real-time data; determining a battery use state; extracting battery discharge voltage data for data cleaning; performing empirical mode decomposition and extracting a residual value after decomposition; calculating the score of each monomer under the Shannon entropy weight method; determining an improved Z-score of the score result of each battery cell; judging whether a fault occurs or not; and data of the next sliding window are collected again. On one hand, on-line fault detection and abnormal monomer positioning and early warning can be carried out based on real-time voltage data of the battery system; on the other hand, calculation is simple, online application can be achieved, and the method is suitable for engineering application.

### [DISCLOSURE]

### [TECHNICAL PROBLEM]

A battery pack may include a plurality of battery cells connected in series and/or in parallel. As a result, even when a battery cell in an abnormal state exists among the plurality of battery cells, it may not be easy to detect abnormality in the battery cell.

Therefore, there is a need for a method for detecting a battery cell in an abnormal state among a plurality of battery cells.

Technical problems of the embodiments disclosed herein are not limited to the above-described technical problems, and other unmentioned technical problems would be clearly understood by one of ordinary skill in the art from the following description.

### [TECHNICAL SOLUTION]

The invention is set out in the appended claims. An electronic device according to an embodiment disclosed herein includes a battery module including M battery cells, M being an integer greater than or equal to 2, a detection circuit configured to obtain state values relate to states of the M respective battery cells, and a processor, in which the processor is configured to obtain input data through the detection circuit, wherein the input data is expressible as an M x N matrix, M x N entries of the input data indicate the state values of the M respective battery cells, and N indicates a number of time periods for obtaining the state values of the M respective battery cells, to standardize each of column vectors of the input data to obtain standardized data for the input data, wherein each of the column vectors includes entries obtained for an identical unit time, to obtain determination reference data based on the standardized data, and to determine first state abnormality and/or second state abnormality of each of the M battery cells based on values indicated by the entries of respective row vectors of the determination reference data, in which the first state abnormality is determined based on a learning-based model, and the second state abnormality is determined based on a scheme other than the learning-based model.

In an embodiment, the processor may be further configured to identify a row vector including at least one value less than or equal to a reference threshold standardized score among the row vectors of the determination reference data, to obtain an output vector for the identified row vector based on the learning-based model, and to determine the first state abnormality of a battery cell corresponding to the identified row vector, based on the output vector.

According to the invention, as a first option, the processor is further configured to remove an offset from entries of the respective row vectors of the input data and to standardize each of the column vectors of the offset-removed input data to obtain the standardized data, in which the offset is set for each of the row vectors of the input data, and the offset is set as a value of a first entry among the entries of the respective row vectors of the input data.

According to the invention, as a second option, the processor is further configured to smooth the entries of the respective row vectors of the input data and to standardize each of the column vectors of the smoothed input data to obtain the standardized data.

In an embodiment, the processor may be further configured to obtain a window average value of each of the row vectors of the standardized data as the determination reference data and to determine the first state abnormality and/or the second state abnormality of each of the M battery cells based on the window average values of the respective row vectors of the determination reference data, in which the window average values are average values of the entries of the respective row vectors of the standardized data included in different time windows, and the time windows do not overlap one another.

In an embodiment, the processor may be further configured to obtain change amounts of the entries of the respective row vectors of the standardized data as the determination reference data and to determine first state abnormality and/or second state abnormality of each of the M battery cells based on the change amounts of the entries of respective row vectors of the determination reference data.

In an embodiment, the processor may be further configured to identify a sum of the entries of the respective row vectors of the determination reference data, to identify a row vector corresponding to the sum being less than or equal to a threshold sum value among the row vectors of the determination reference data, and to determine that a battery cell corresponding to the identified row vector has the second state abnormality.

In an embodiment, the learning-based model may be an auto encoder, and the auto encoder may be trained based on state values of normal battery cells.

An operating method of an electronic device according to an embodiment disclosed herein includes obtaining input data through a detection circuit of the electronic device, wherein the input data is expressible as an M x N matrix, M x N entries of the input data indicate the state values of M respective battery cells of the electronic device, and N indicates a number of time periods for obtaining the state values of the M respective battery cells, standardizing each of column vectors of the input data to obtain standardized data for the input data, wherein each of the column vectors includes entries obtained for an identical unit time, obtaining determination reference data based on the standardized data, and determining first state abnormality and/or second state abnormality of each of the M battery cells based on values indicated by the entries of respective row vectors of the determination reference data, in which the first state abnormality is determined based on a learning-based model, and the second state abnormality is determined based on a scheme other than the learning-based model.

In an embodiment, the determining of the first state abnormality and/or the second state abnormality includes identifying a row vector including at least one value less than or equal to a reference threshold standardized score among the row vectors of the determination reference data, obtaining an output vector for the identified row vector based on the learning-based model, and determining the first state abnormality of a battery cell corresponding to the identified row vector, based on the output vector.

According to the invention, as a first option, the obtaining of the standardized data includes removing an offset from entries of the respective row vectors of the input data and standardizing each of the column vectors of the offset-removed input data to obtain the standardized data, in which the offset is set for each of the row vectors of the input data, and the offset is set as a value of a first entry among the entries of the respective row vectors of the input data.

According to the invention, as a second option, the obtaining of the standardized data includes smoothing the entries of the respective row vectors of the input data and standardizing each of the column vectors of the smoothed input data to obtain the standardized data.

In an embodiment, the obtaining of the determination reference data includes obtaining a window average value of each of the row vectors of the standardized data as the determination reference data, and the determining of the first state abnormality and/or the second state abnormality includes determining the first state abnormality and/or the second state abnormality of each of the M battery cells based on the window average values of the respective row vectors of the determination reference data, in which the window average values are average values of the entries of the respective row vectors of the standardized data included in different time windows, and the time windows do not overlap one another.

In an embodiment, the obtaining of the determination reference data includes obtaining change amounts of the entries of the respective row vectors of the standardized data as the determination reference data, and the determining of the first state abnormality and/or the second state abnormality includes determining the first state abnormality and/or the second state abnormality of each of the M battery cells based on the change amounts of the entries of respective row vectors of the determination reference data.

In an embodiment, the determining of the first state abnormality and/or the second state abnormality includes identifying a sum of the entries of the respective row vectors of the determination reference data, identifying a row vector corresponding to the sum being less than or equal to a threshold sum value among the row vectors of the determination reference data, and determining that a battery cell corresponding to the identified row vector has the second state abnormality.

### [ADVANTAGEOUS EFFECTS]

An electronic device and an operating method thereof according to various embodiments disclosed herein may detect a battery cell in an abnormal state among a plurality of battery cells.

The effects of an electronic device for detecting abnormality of a battery and an operating method of the electronic device according to the disclosure of the present document are not limited to the effects mentioned above, and other effects not mentioned will be clearly understood by those of ordinary skill in the art according to the disclosure of the present document.

### [DESCRIPTION OF DRAWINGS]

FIG. 1 is a block diagram of an electronic device in a network environment, according to various embodiments of the present disclosure.
FIG. 2 is a flowchart illustrating operations of an electronic device according to an embodiment of the present disclosure.
FIG. 3 is a flowchart illustrating operations of an electronic device according to an embodiment of the present disclosure.
FIG. 4A illustrates input data.
FIG. 4B illustrates smoothed input data.
FIG. 4C illustrates offset-removed input data.
FIG. 4D illustrates standardized data of offset-removed input data.
FIG. 4E illustrates offset-removed standardized data. FIG. 4F illustrates window average data of standardized data.
FIG. 4G illustrates change amount data of window average data.
FIG. 5 is a flowchart illustrating operations of an electronic device according to an embodiment of the present disclosure.
FIG. 6 is a flowchart illustrating operations of an electronic device according to an embodiment of the present disclosure.

With regard to the description of the drawings, similar reference numerals may be used to refer to similar or related components.

### [MODE FOR INVENTION]

Hereinafter, embodiments of the present disclosure will be described with reference to the accompanying drawings. However, the description is not intended to limit the present disclosure to particular embodiments, and it should be construed as including various modifications, and/or alternatives according to the embodiments of the present disclosure.

It should be appreciated that embodiments of the present document and the terms used therein are not intended to limit the technological features set forth herein to a particular embodiment and include various changes, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1^{st}", "2^{nd}," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the multiple entities may be separately disposed in different components. According to various embodiments disclosed herein, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

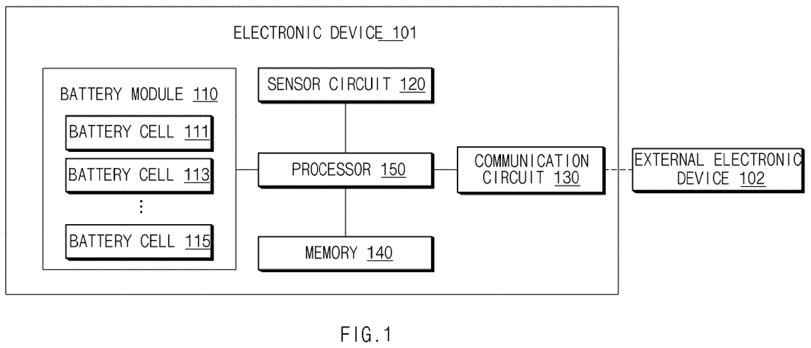

FIG. 1 is a block diagram of an electronic device 101 according to an embodiment of the present disclosure.

Referring to FIG. 1, the electronic device 101 may include a battery module 110, a sensor circuit 120, a communication circuit 130, a memory 140, and a processor 150. According to an embodiment, at least one component (e.g., the battery module 110) of the electronic device 101 shown in FIG. 1 may be replaced with another component (e.g., a battery cell including a plurality of battery modules 110). According to an embodiment, at least one component (e.g., the battery module 110) of the electronic device 101 shown in FIG. 1 may be provided in plural. According to an embodiment, at least one component (e.g., the sensor circuit 120 or the communication circuit 130) of the electronic device 101 shown in FIG. 1 may be excluded from the electronic device 101. According to an embodiment, the electronic device 101 may further include at least one component (e.g., a power unit (e.g., a motor), a display, an input device, or an output device) in addition to components shown in FIG. 1.

In an embodiment, the electronic device 101 may be a battery management system (BMS). When the electronic device 101 is implemented with a BMS, the electronic device 101 may supply power of the battery module 110 to an external component (e.g., a motor).

In an embodiment, the electronic device 101 may be a battery swapping station (BSS). When the electronic device 101 is implemented with a battery swapping station, the electronic device 101 may include a plurality of slots for storing and/or charging the plurality of battery modules 110.

In an embodiment, the battery module 110 may supply power to one or more components of the electric device 101. In an embodiment, the battery module 110 may be attached to or detached from the electronic device 101.

In an embodiment, the battery module 110 may include one or more battery cells 111, 113, or 115. The one or more battery cells 111, 113, or 115 may be included in a state of being electrically connected to one another in the battery module 110. For example, the one or more battery cells 111, 113, or 115 may be connected to one another in series and/or in parallel. According to an embodiment, the one or more battery cells 111, 113, or 115 may be included in a state of being electrically separated from one another in the battery module 110.

In an embodiment, the sensor circuit 120 may obtain information related to the battery module 110. In an embodiment, the sensor circuit 120 may obtain values (or information) related to respective states of the one or more battery cells 111, 113, or 115. In an embodiment, the values related to the states may indicate one or more values of voltages, currents, resistances, states of charge (SoC), states of health (SoH), or temperatures of a battery cell or combinations thereof. Hereinbelow, the value related to the state may be referred to as a 'state value'.

In an embodiment, the sensor circuit 120 may provide information (e.g., state values) of the one or more battery cells 111, 113, or 115 to the processor 150.

In an embodiment, the communication circuit 130 may establish a wired communication channel and/or a wireless communication channel between the electronic device 101 and an external electronic device 102, and transmit and receive data to and from the external electronic device 102 through the established communication channel.

In an embodiment, the communication circuit 130 may perform communication based on at least one radio access technology (RAT). In an embodiment, the communication circuit 130 may transmit and receive data to and from the external electronic device 102 by using at least one RAT.

In an embodiment, the memory 140 may include a volatile and/or a nonvolatile memory.

In an embodiment, the memory 140 may store data used by at least one component (e.g., the processor 150 or the sensor circuit 120) of the electronic device 101. For example, the data may include software (or an instruction related thereto), input data, or output data. In an embodiment, an instruction, when executed by the processor 150, may cause the electronic device 101 to perform operations defined by the instruction.

In an embodiment, the processor 150 may execute software to control at least one other component (e.g., a hardware or software component) of the electronic device 101 connected to the processor 150 and may process or compute various data.

Hereinbelow, a description will be made of a method in which the electronic device 101 according to an embodiment of the present disclosure determines abnormality of the one or more battery cells 111, 113, or 115 included in the battery module 110.

In an embodiment, the electronic device 101 may obtain state values (e.g., one or more values related to voltage, current, resistance, charge state, health state, or temperature) of the one or more battery cells 111, 113, or 115. In an embodiment, the electronic device 101 may obtain state values of the one or more battery cells 111, 113, or 115 for a designated time window (e.g., 180 seconds (sec)). In an embodiment, the electronic device 101 may obtain state values of the one or more battery cells 111, 113, or 115 in a designated time period (e.g., 0.1 second) for a designated time window. For example, the electronic device 101 may obtain voltage values of the one or more battery cells 111, 113, or 115. In another example, the electronic device 101 may obtain current values of the one or more battery cells 111, 113, or 115.

In an embodiment, the state values of the one or more battery cells 111, 113, or 115 obtained in a designated time period for a designated time window may be designated as 'input data'. In an embodiment, the input data may be expressed as a matrix (e.g., an M x N matrix) including N values of M battery cells 111, 113, or 115. For example, the input data may include N voltage values of the M battery cells 111, 113, or 115. In another example, the input data may include one of N current, resistance, charge state, health state, or temperature values of the M battery cells 111, 113, or 115. For example, entries of the input data may indicate the voltage values of the M battery cells 111, 113, or 115. In another example, the entries of the input data may indicate one of resistance, charge state, health state, or temperature values of the M battery cells 111, 113, or 115. Herein, M indicates the number of battery cells 111, 113, or 115, and N indicates the number of time periods for obtaining state values of the battery cells 111, 113, or 115. For example, when the number of battery cells 111, 113, or 115 is 100, a designated time window is 180 seconds, and a designated time period is 0.1 second, M may be 100 and N may be 1800.

In an embodiment, input data Dᵢₙₚᵤₜ may be expressed as Equation 1. [Equation 1] ${D}_{input} = \left(\begin{matrix}{v}_{1,1} & ⋯ & {v}_{1 , N } \\ ⋮ & ⋱ & ⋮ \\ {v}_{M , 1} & ⋯ & {v}_{M , N}\end{matrix}\right)$

In Equation 1, respective entries v_{1,1}, ..., v_{1,N} to v_{M,1}, ..., v_{M,N} of the input data Dᵢₙₚᵤₜ may indicate the state values of the battery cells 111, 113, or 115. Respective columns (or column vectors) of the input data Dᵢₙₚᵤₜ may indicate M state values obtained for the same time period (or a sensing time of the sensor circuit 120). Respective rows (or row vectors) of the input data Dᵢₙₚᵤₜ may indicate N state values respectively obtained from the battery cells 111, 113, or 115 for a designated time period. For example, the entries v_{1,1} to v_{M,1} of the first column vector may be state values of the battery cells 111, 113, or 115 obtained for the first time period. The entries v_{1,1} to v_{1,N} of the first row vector may be state values obtained from the first battery cell for a designated time period. In an embodiment, the respective entries v_{1,1}, ..., v_{1,N} to v_{M,1}, ..., v_{M,N} of the input data Dᵢₙₚᵤₜ may indicate the state values of the same type. For example, the entries v_{1,1}, ..., v_{1,N} to v_{M,1}, ..., v_{M,N} may indicate state values of one type of voltage, current, resistance, charge state, health state, or temperature.

In an embodiment, the electronic device 101 may obtain standardized data based on input data. In an embodiment, standardized data of random matrix data may be obtained based on standardization over entries of respective column vectors of the random matrix data. In an embodiment, standardization may transforming values into standardized scores (or Z scores). For example, standardization may be based on Equation 2 below. [Equation 2] ${z}_{i , j} = \frac{{v}_{i , j} - {m}_{j}}{{σ}_{j}}$

In Equation 2, z_{i,j} indicates a standardized score of a j^{th} entry of an i^{th} row vector of the random matrix data. v_{i,j} indicates a value of the j^{th} entry of the i^{th} row vector of the random matrix data. mⱼ indicates an average of entries of a j^{th} column vector of the random matrix data. σⱼ indicates a standard deviation of the entries of the j^{th} column vector of the random matrix data. Herein, i indicates an integer of 1 or greater and less than or equal to the number of rows of the random matrix data, and j indicates an integer of 1 or greater and less than or equal to the number of columns of the random matrix data.

In an embodiment, the electronic device 101 may determine first state abnormality and/or second state abnormality of the battery cells 111, 113, or 115 based on the standardized data. In an embodiment, the electronic device 101 may determine the first state abnormality and/or the second state abnormality of the battery cells 111, 113, or 115 by using determination reference data based on the standardized data. In an embodiment, the determination reference data may be the standardized data. In an embodiment, the determination reference data may be data obtained by performing data processing (e.g., removing an offset, averaging a period, obtaining a change amount, and/or performing concatenation) on the standardized data. In an embodiment, the first state abnormality may mean state abnormality where an instantaneous voltage of a battery cell drops in charge of the battery cell. In an embodiment, the second state abnormality may mean state abnormality where a slope of a voltage of a battery cell decreases (or is low) in charge of the battery cell. In an embodiment, the first state abnormality may be determined based on a learning-based model, and the second state abnormality may be determined based on a scheme (e.g., a rule-based model) other than the learning-based model.

Hereinbelow, an operation of the electronic device 101 determining the first state abnormality of the battery cells 111, 113, or 115 will be described.

**In** an embodiment, the electronic device 101 may identify a row vector including an entry having a value less than or equal to a reference threshold standardized score among entries of respective row vectors of the determination reference data. According to an embodiment, the electronic device 101 may identify a row vector including an entry having a value greater than or equal to the reference threshold standardized score among the entries of the respective row vectors of the determination reference data. According to an embodiment, the electronic device 101 may identify a row vector including an entry having a value beyond a reference threshold standardized score range among the entries of the respective row vectors of the determination reference data. **In** an embodiment, the reference threshold standardized score may be a score experimentally determined to extract a candidate having a possibility of the first state abnormality. Hereinbelow, it is illustrated that the electronic device 101 may identify the row vector including the entry having the value less than or equal to the reference threshold standardized score among the entries of the respective row vectors of the determination reference data.

**In** an embodiment, the electronic device 101 may obtain output vectors of the learning-based model based on the row vectors of the determination reference data. **In an** embodiment, the electronic device 101 may obtain the output vector of the row vector including the entry having the value less than or equal to the reference threshold standardized score, based on the learning-based model. **In** an embodiment, the learning-based model may be an auto encoder. **In** an embodiment, the auto encoder may be an artificial neural network trained to reconstruct determination reference data corresponding to a normal behavior. **In** an embodiment, the auto encoder may be an artificial neural network trained in an unsupervised manner. **In** an embodiment, the auto encoder may include an encoder and a decoder. **In** an embodiment, the encoder of the auto encoder may compress an input into lower dimensions, and the decoder of the auto encoder may reconstruct a compressed output of the auto encoder into previous dimensions. Thus, the input and the output of the auto encoder may have the same dimensions, and the output of the auto encoder may have a form including a reconstruction error (or a reconstruction loss) in addition to the input of the auto encoder.

In an embodiment, the electronic device 101 may determine the first state abnormality of the battery cell based on the output vector of the learning-based model. In an embodiment, the electronic device 101 may determine the first state abnormality of the battery cell based on the reconstruction error of the auto encoder. In an embodiment, a reconstruction error or a random row vector may be a root mean square (RMS) of a vector obtained by subtracting an output vector for the random row vector from the random row vector.

In an embodiment, the electronic device 101 may identify a row vector in which the reconstruction error exceeds a designated reference reconstruction error, among row vectors of the determination reference data. In an embodiment, the electronic device 101 may determine that a battery cell related to a row vector exceeding a reference reconstruction error has the first state abnormality. In an embodiment, the reference reconstruction error may be an error experimentally determined to identify the first state abnormality.

Hereinbelow, an operation of the electronic device 101 determining the second state abnormality of the battery cells 111, 113, or 115 will be described.

In an embodiment, the electronic device 101 may determine the second state abnormality of the battery cells 111, 113, or 115 based on a sum of entries of respective row vectors of the determination reference data. In an embodiment, the electronic device 101 may identify a row vector corresponding to a sum being less than or equal to a designated reference sum value, among row vectors. According to an embodiment, the electronic device 101 may identify a row vector corresponding to a sum being greater than or equal to the designated reference sum value, among the row vectors. According to an embodiment, the electronic device 101 may identify a row vector corresponding to a sum falling beyond a designated reference sum range, among the row vectors. Hereinbelow, it will be illustrated that the electronic device 101 may identify the row vector corresponding to a sum being greater than or equal to the designated reference sum value, among the row vectors. In an embodiment, the reference sum value may be a value experimentally determined to identify the second state abnormality.

In an embodiment, the electronic device 101 may determine that a battery cell related to the row vector less than or equal to the designated reference sum value has the second state abnormality.

In an embodiment, the electronic device 101 may provide a notification to a user through an output device (or a display or the communication circuit 130) when a battery cell including state abnormality is identified. In an embodiment, the notification provided to the user may include a notification to check abnormality of a battery cell, a notification to replace a battery cell, or a combination thereof.

While it is shown in FIG. 1 that the electronic device 101 obtains standardized data of input data and determines first state abnormality and/or second state abnormality based on determination reference data of standardized data, but this is merely an example. According to an embodiment, the electronic device 101 may perform processing to process the input data and determine the first state abnormality and/or the second state abnormality based on standardized data of the processed input data. In addition, the electronic device 101 may perform processing to process the standardized data of the input data and determine the first state abnormality and/or the second state abnormality based on the processed standardized data (or the determination reference data). According to an embodiment, processing of the input data and/or processing of the standardized data may be selectively performed.

Hereinbelow, examples will be described where the electronic device 101 according to an embodiment of the present disclosure processes input data.

In an embodiment, the electronic device 101 may obtain smoothing data (or moving average data) of the input data. In an embodiment, smoothing of random matrix data may be performed among entries of respective row vectors of the random matrix data. For example, smoothing of the random matrix data may be performed based on Equation 3. [Equation 3] $v {s}_{i , j} = \frac{{\sum }_{k = j - d}^{j + d} {α}_{k} \times {v}_{i , k}}{2 d + 1}$

In Equation 3, vs_{i,j} indicates a smoothed value of the j^{th} entry of the i^{th} row vector of the random matrix data. d indicates a distance to the farthest entry from the j^{th} entry among entries used for smoothing. k indicates an integer greater than or equal to (j - d) and less than or equal to (j + d). αk indicates a weight value applied to a k^{th} entry. v_{i,k} indicates a value of the k^{th} entry of the i^{th} row. A sum of weight values used for smoothing the j^{th} entry of the i^{th} row vector of the rando matrix data may be 1. When the weight values used for smoothing the j^{th} entry of the i^{th} row vector of the rando matrix data are equal to each other, smoothing may be moving averaging.

In an embodiment, the electronic device 101 may obtain smoothing data (or moving average data) of input data, obtain standardized data of the obtained smoothing data (or the moving average data), and determine the first state abnormality and/or the second state abnormality based on the standardized data.

In an embodiment, the electronic device 101 may obtain data by removing an offset from the input data. In an embodiment, the offset of the random matrix data may be set for each row vector of the random matrix data. In an embodiment, the offset for the random matrix data may be a value of the first entry among the entries of the respective row vectors of the random matrix data. In an embodiment, removal of the offset for the random matrix data may involve subtracting an offset from each row vector of each entry of row vectors of the random matrix data.

In an embodiment, the electronic device 101 may obtain data by removing an offset from input data, obtain standardized data of the obtained offset-removed data, and determine the first state abnormality and/or the second state abnormality based on the standardized data.

In an embodiment, the electronic device 101 may sequentially perform offset removal and smoothing with respect to the input data. In an embodiment, the electronic device 101 may obtain standardized data of data obtained by sequentially performing offset removal and smoothing, and determine the first state abnormality and/or the second state abnormality based on the standardized data. According to an embodiment, offset removal may be performed first on the input data and then smoothing may be performed, or smoothing may be performed with respect to the input data first and then offset removal may be performed.

Hereinbelow, examples will be described where the electronic device 101 according to an embodiment of the present disclosure processes the standardized data to obtain the determination reference data. The standardized data described below may be the standardized data of the input data, the standardized data of the smoothed input data, the standardized data of the offset-removed input data, or the standardized data of smoothed and offset-removed input data.

In an embodiment, the electronic device 101 may obtain the determination reference data by removing an offset from the standardized data. In an embodiment, the electronic device 101 may determine the first state abnormality and/or the second state abnormality based on the offset-removed standardized data (i.e., determination reference data).

In an embodiment, the electronic device 101 may obtain period average data of the standardized data as the determination reference data. In an embodiment, the period averaging may involve averaging the entries of the respective row vectors of the random matrix data every designated time intervals (e.g., 18 seconds). In an embodiment, the time intervals may not overlap each other. For example, when a designated time interval is 18 seconds, a designated time window is 180 seconds, and a designated time period is 0.1 second, then the number of columns of window average data is 10 and the columns of the window average data may indicate an average of 180 columns of the standardized data.

In an embodiment, the electronic device 101 may determine the first state abnormality and/or the second state abnormality based on the window average data (i.e., determination reference data).

In an embodiment, the electronic device 101 may obtain change amount data of the standardized data as the determination reference data. In an embodiment, the change amount may be a difference value between adjacent entries of each row vector of the random matrix data. For example, a change amount of a random entry may be a value obtained by subtracting a value of an entry previous to the random entry from a value of the random entry.

In an embodiment, the electronic device 101 may determine the first state abnormality and/or the second state abnormality based on the change amount data (i.e., determination reference data).

In an embodiment, the electronic device 101 may obtain concatenation data of the standardized data as the determination reference data. In an embodiment, concatenation of random matrix data may concatenate other matrix data than the random matrix data in a column direction. In an embodiment, concatenation of the random matrix data may involve sequentially concatenating the random matrix data except for the first column, the first column of the random matrix data, and the last column of the random matrix data. In an embodiment, the electronic device 101 may determine the first state abnormality and/or the second state abnormality based on the concatenation data (i.e., determination reference data).

In an embodiment, the electronic device 101 may obtain the determination reference data by sequentially removing an offset, averaging a window, obtaining a change amount, and performing concatenation for the standardized data. In an embodiment, the electronic device 101 may determine the first state abnormality and/or the second state abnormality based on the determination reference data obtained by sequentially removing an offset, averaging a window, obtaining a change amount, and performing concatenation for the standardized data. The order of removing an offset, averaging a window, obtaining a change amount, and performing concatenation for the standardized data may be set differently according to embodiments.

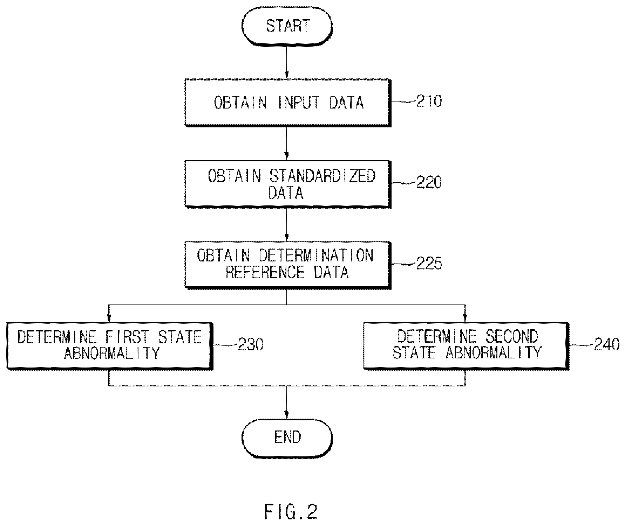

FIG. 2 is a flowchart illustrating operations of an electronic device according to an embodiment of the present disclosure. Operations shown in FIG. 2 may be executed by the electronic device 101 of FIG. 1.

Referring to FIG. 2, in operation 210, the electronic device 101 may obtain input data. In an embodiment, the input data may include respective state values of the one or more battery cells 111, 113, or 115 obtained in a designated time period for a designated time window. In an embodiment, the input data may be expressed as a matrix (e.g., an M x N matrix) including N values of M battery cells 111, 113, or 115. For example, entries of the input data may indicate the voltage values of the M battery cells 111, 113, or 115. In another example, the entries of the input data may indicate one of resistance, charge state, health state, or temperature values of the M battery cells 111, 113, or 115. Herein, M indicates the number of battery cells 111, 113, or 115, and N indicates the number of time periods for obtaining state values of the battery cells 111, 113, or 115.

In operation 220, the electronic device 101 may obtain the standardized data. In an embodiment, the standardized data may be standardized data among respective entries of column vectors of the input data.

In operation 225, the electronic device 101 may obtain determination reference data based on the standardized data. In an embodiment, the determination reference data may be the standardized data. In an embodiment, the determination reference data may be data obtained by performing data processing (e.g., removing an offset, averaging a period, obtaining a change amount, and/or performing concatenation) on the standardized data.

In operation 230, the electronic device 101 may determine the first state abnormality. In an embodiment, the electronic device 101 may obtain output vectors of the learning-based model based on the row vectors of the determination reference data. In an embodiment, the electronic device 101 may determine the first state abnormality of the battery cell based on the output vector of the learning-based model.

In an embodiment, the electronic device 101 may determine the first state abnormality of the battery cell based on the reconstruction error of the auto encoder. In an embodiment, a reconstruction error or a random row vector may be an RMS of a vector obtained by subtracting an output vector for the random row vector from the random row vector.

In an embodiment, the electronic device 101 may identify a row vector in which the reconstruction error exceeds a designated reference reconstruction error, among row vectors of the determination reference data. In an embodiment, the electronic device 101 may determine that a battery cell related to a row vector exceeding a reference reconstruction error has the first state abnormality.

In operation 240, the electronic device 101 may determine the second state abnormality. In an embodiment, the electronic device 101 may determine the second state abnormality of the battery cells 111, 113, or 115 based on a sum of respective entries of row vectors of the determination reference data. In an embodiment, the electronic device 101 may identify a row vector corresponding to a sum being less than or equal to a designated reference sum value, among row vectors. In an embodiment, the electronic device 101 may determine that a battery cell related to the row vector less than or equal to the designated reference sum value has the second state abnormality.

While it is shown in FIG. 2 that the electronic device 101 obtains standardized data of input data and determines first state abnormality and/or second state abnormality based on determination reference data of standardized data, but this is merely an example. According to an embodiment, the electronic device 101 may perform processing to process the input data and determine the first state abnormality and/or the second state abnormality based on standardized data of the processed input data. In addition, the electronic device 101 may determine the first state abnormality and/or the second state abnormality based on the determination reference data obtained by performing processing to process the standardized data of the input data. According to an embodiment, processing of the input data and/or processing of the standardized data may be selectively performed.

In an embodiment, a method of the electronic device 101 processing the input data may include removing an offset from the input data and smoothing the input data. In an embodiment, a method of the electronic device 101 processing the standardized data to obtain the determination reference data may include removing an offset from the standardized data, window-averaging the standardized data, and obtaining a change amount of the standardized data.

While it is shown in FIG. 2 that both operations 230 and 240 are performed, this is merely an example. According to an embodiment, operation 230 and 240 may be performed selectively. In some embodiment, any one of operations 230 and 240 may not be performed. For example, the electronic device 101 may perform operation 230 to determine only the first state abnormality and may not perform operation 240. In another example, the electronic device 101 may perform operation 240 to determine only the second state abnormality and may not perform operation 230.

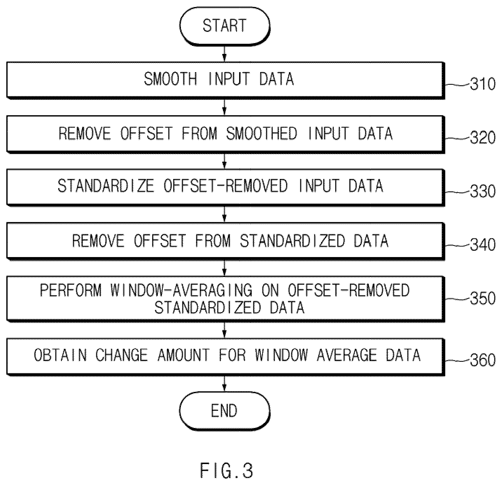

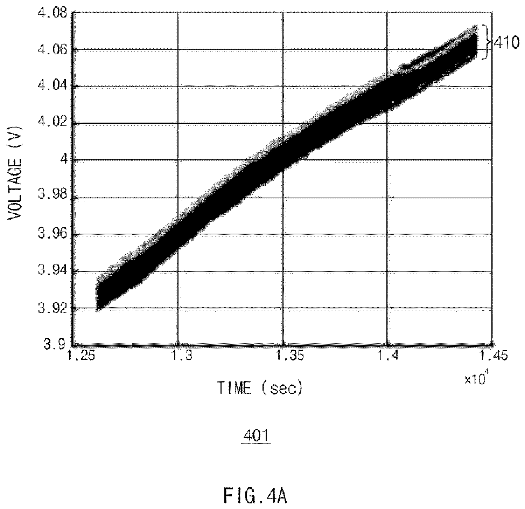

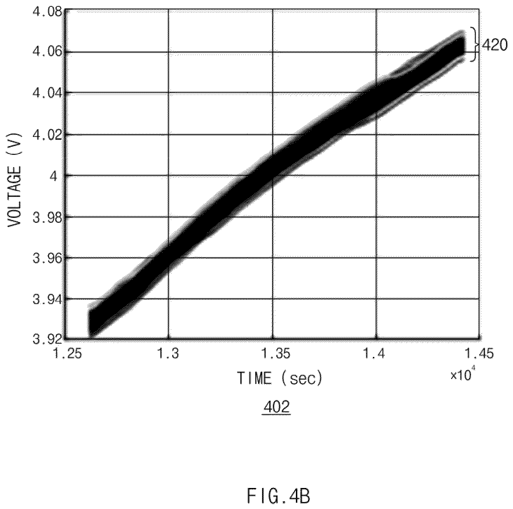

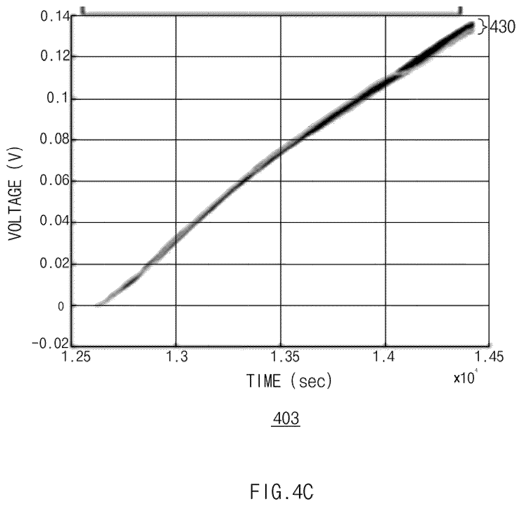

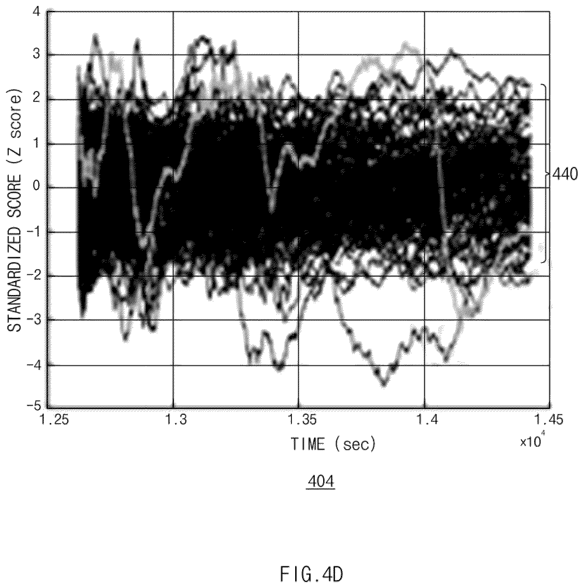

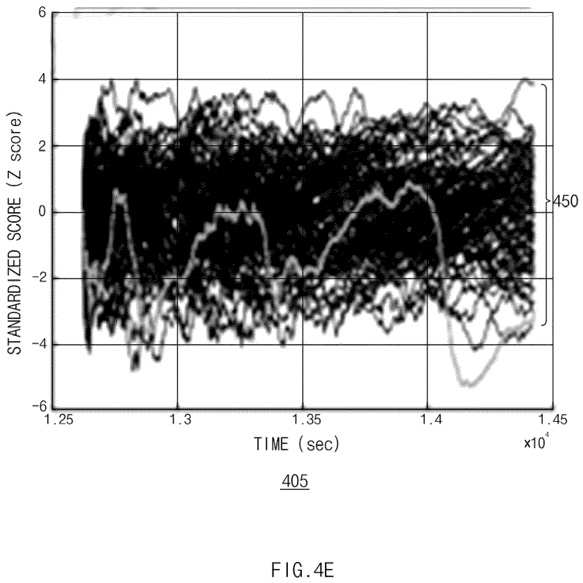

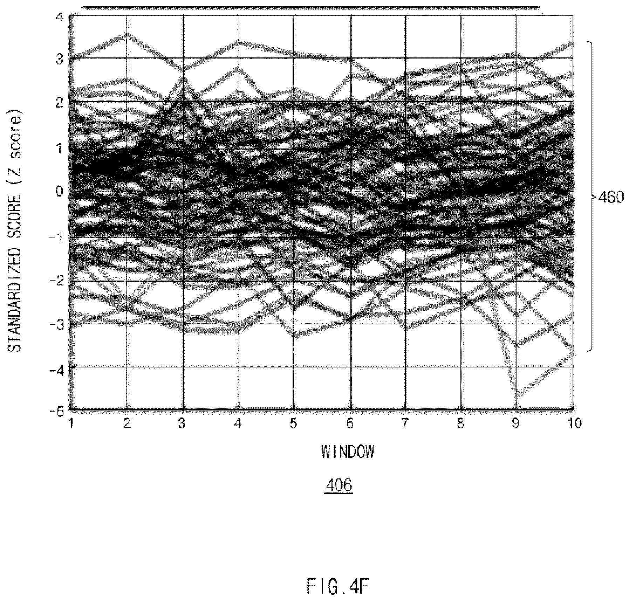

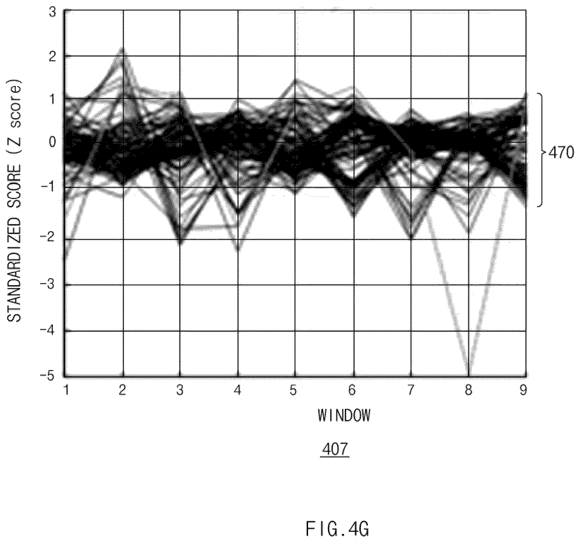

FIG. 3 is a flowchart illustrating operations of an electronic device according to an embodiment of the present disclosure. FIG. 4A illustrates input data. FIG. 4B illustrates smoothed input data. FIG. 4C illustrates offset-removed input data. FIG. 4D illustrates standardized data of offset-removed input data. FIG. 4E illustrates offset-removed standardized data. FIG. 4F illustrates window average data of standardized data. FIG. 4G illustrates change amount data of window average data. Operations 310, 320, and 330 of FIG. 3 may be included in operation 220 of FIG. 2. Operations 340, 350, and 360 of FIG. 3 may be included in operation 225 of FIG. 2. Operations shown in FIG. 3 may be executed by the electronic device 101 of FIG. 1. In an embodiment, change amount data of FIG. 4G may be understood as determination reference data obtained by operations of FIG. 3.

Referring to FIG. 3, in operation 310, the electronic device 101 may perform smoothing on input data.

In an embodiment, the input data may include respective state values of the one or more battery cells 111, 113, or 115 obtained in a designated time period for a designated time window. In an embodiment, the input data may be expressed as a matrix (e.g., an M x N matrix) including N values of M battery cells 111, 113, or 115. In an embodiment, the state values may be one or more values related to voltage, current, resistance, charge state, health state, or temperature.

Referring to FIG. 4A, a graph 401 may indicate input data 410. The input data 410 may be voltage values of M battery cells 111, 113, or 115 obtained for a time window of 180 seconds.

In an embodiment, smoothing of the input data 410 may be performed among entries of respective row vectors of the input data. For example, smoothing of the input data 410 may be performed based on Equation 3.

Referring to FIG. 4B, a graph 402 may indicate the smoothed input data 420. Compared to the graph 401, the graph 402 shows that noise of the input data 420 is reduced by smoothing.

In operation 320, the electronic device 101 may remove an offset of the smoothed input data 420. In an embodiment, the offset of the smoothed input data 420 may be set for each row vector of the smoothed input data 420. In an embodiment, the offset of the smoothed input data 420 may be the first entry value of the respective entries of the row vectors of the smoothed input data 420. In an embodiment, offset removal from the smoothed input data 420 may involve subtracting an offset of each row vector from respective entries of the row vectors of the smoothed input data 420.

Referring to FIG. 4C, a graph 403 may indicate offset-removed input data 430. Compared to the graph 402, the graph 403 shows that an initial value of the input data 430 starts with 0.

In operation 330, the electronic device 101 may perform standardization on the offset-removed input data 430. In an embodiment, the standardized data of the input data 430 may be obtained based on standardization among entries of respective column vectors of the input data 430. In an embodiment, standardization may transforming values into standardized scores (or Z scores). For example, standardization may be based on Equation 2 below.

Referring to FIG. 4D, a graph 404 may indicate standardized data 440 of the input data 430.

In operation 340, the electronic device 101 may remove an offset of the standardized data 440.

In an embodiment, the offset of the standardized data 440 may be set for each row vector of the standardized data 440. In an embodiment, the offset of the standardized data 440 may be the first entry value of the respective entries of the row vectors of the standardized data 440. In an embodiment, offset removal from the standardized data 440 may involve subtracting an offset of each row vector from respective entries of the row vectors of the standardized data 440.

Referring to FIG. 4E, a graph 405 may indicate offset-removed standardized data 450.

In operation 350, the electronic device 101 may perform window-averaging on the offset-removed standardized data 450. In an embodiment, the window averaging may involve averaging the entries of the respective row vectors of the standardized data 450 every designated time intervals (e.g., 18 seconds). For example, when a designated time interval is 18 seconds, a designated time window is 180 seconds, and a designated time period is 0.1 second, then the number of columns of window average data is 10 and the columns of the window average data may indicate an average of 180 columns of the standardized data.

Referring to FIG. 4F, a graph 406 may indicate window averaging data 460. Compared to the graph 405 of FIG. 4E, it may be seen that there are 10 windows in the graph 406.

In operation 360, the electronic device 101 may obtain a change amount for the window average data 460. In an embodiment, the change amount may be a difference value between adjacent entries of each row vector of the window average data 460. For example, a change amount of a random entry may be a value obtained by subtracting a value of an entry previous to the random entry from a value of the random entry.

Referring to FIG. 4G, a graph 407 may indicate change amount data 470. Compared to the graph 407 of FIG. 4G, it may be seen that there are 9 windows in the graph 407. This is because there is one entry (e.g., the last entry) for which the change amount is not obtained in the graph 407.

Thereafter, the electronic device 101 may determine first state abnormality and/or second state abnormality of the battery cells 111, 113, or 115 based on the change amount data 470.

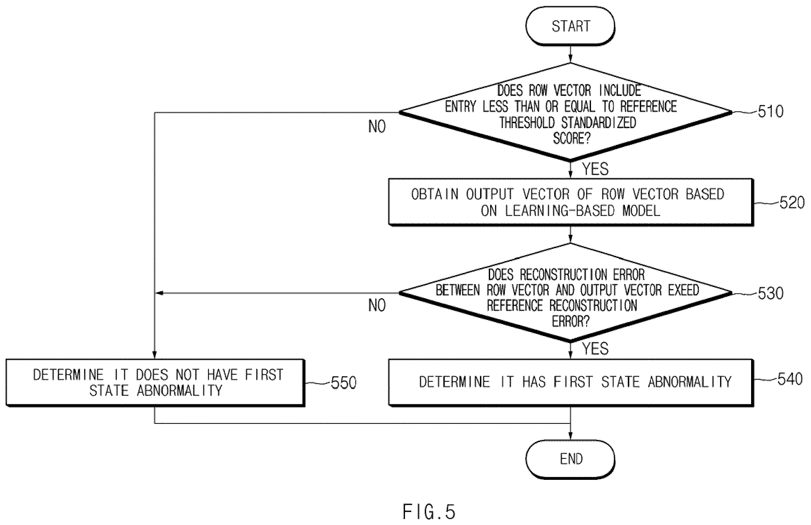

FIG. 5 is a flowchart illustrating operations of an electronic device according to an embodiment of the present disclosure. Operations of FIG. 5 may be included in operation 230 of FIG. 2. Operations shown in FIG. 5 may be executed by the electronic device 101 of FIG. 1.

Operations of FIG. 5 may be performed for each row vector.

Referring to FIG. 5, in operation 510, the electronic device 101 may determine whether a row vector includes an entry less than or equal to a reference threshold standardized score. In an embodiment, the electronic device 101 may identify a row vector including an entry having a value less than or equal to a reference threshold standardized score among entries of respective row vectors of the determination reference data. According to an embodiment, the row vector may be a row vector of the change amount data 470 of FIG. 4F. According to an embodiment, the row vector may be a row vector of data concatenating the change amount data 470. In an embodiment, the row vector may be a row vector of data that sequentially concatenates the change amount data 470 except for the first column, the first column of the change amount data 470, and the last column of the change amount data 470.

In operation 520, the electronic device 101 may obtain an output vector of a row vector based on the learning-based model. In an embodiment, the learning-based model may be an auto encoder. In an embodiment, the auto encoder may be an artificial neural network trained to reconstruct determination reference data corresponding to a normal behavior. In an embodiment, the output vector may have the same dimensions as the row vector and include a reconstruction error (or a reconstruction loss).

In operation 530, the electronic device 101 may determine whether the reconstruction error between the row vector and the output vector exceeds a reference reconstruction error. In an embodiment, the reconstruction error between the row vector and the output vector may be an RMS of a vector obtained by subtracting the row vector and the output vector.

In an embodiment, when the reconstruction error exceeds a reference reconstruction error, the electronic device 101 may perform operation 540. In an embodiment, when the reconstruction error does not exceed the reference reconstruction error, the electronic device 101 may perform operation 550.

In operation 540, the electronic device 101 may determine that it has the first state abnormality. In an embodiment, the electronic device 101 may determine that a battery cell corresponding to a row vector has the first state abnormality.

In operation 550, the electronic device 101 may determine that it does not have the first state abnormality. In an embodiment, the electronic device 101 may determine that the battery cell corresponding to the row vector does not have the first state abnormality.

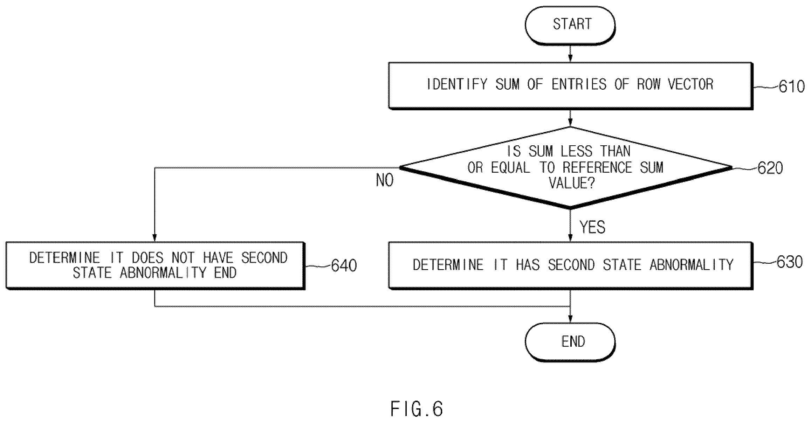

FIG. 6 is a flowchart illustrating operations of an electronic device according to an embodiment of the present disclosure. Operations of FIG. 6 may be included in operation 240 of FIG. 2. Operations shown in FIG. 6 may be executed by the electronic device 101 of FIG. 1.

Operations of FIG. 6 may be performed for each row vector.

Referring to FIG. 6, in operation 610, the electronic device 101 may identify a sum of entries of a row vector. According to an embodiment, the row vector may be a row vector of the change amount data 470 of FIG. 4F.

In operation 620, the electronic device 101 may determine whether the sum is less than or equal to a reference sum value.

In an embodiment, when the sum is less than or equal to the reference sum value, the electronic device 101 may perform operation 630. In an embodiment, when the sum is not less than or equal to the reference sum value, the electronic device 101 may perform operation 640.

In operation 630, the electronic device 101 may determine that is has the second state abnormality. In an embodiment, the electronic device 101 may determine that a battery cell corresponding to a row vector has the second state abnormality.

In operation 640, the electronic device 101 may determine that it does not have the second state abnormality. In an embodiment, the electronic device 101 may determine that the battery cell corresponding to the row vector does not have the second state abnormality.

## Claims

1. An electronic device (101, 102) comprising:
a battery module (110) comprising M battery cells (111, 113), M being an integer greater than or equal to 2;
a detection circuit configured to obtain state values relate to states of the M respective battery cells (111, 113); and
a processor (150),
wherein the processor (150) is configured to:
obtain input data (410) through the detection circuit, wherein the input data (410) is expressible as an M x N matrix, M x N entries of the input data (410) indicate the state values of the M respective battery cells (111, 113), and N indicates a number of time periods for obtaining the state values of the M respective battery cells (111, 113);
standardize each of column vectors of the input data (410) to obtain standardized data (440, 450) for the input data (410), wherein each of the column vectors comprises entries obtained for an identical unit time;
obtain determination reference data based on the standardized data (440, 450); and
determine first state abnormality and/or second state abnormality of each of the M battery cells (111, 113) based on values indicated by the entries of respective row vectors of the determination reference data,
wherein the first state abnormality is determined based on a learning-based model, and the second state abnormality is determined based on a scheme other than the learning-based model,
wherein the processor (150) is further configured to:
remove an offset from entries of the respective row vectors of the input data (410); and
standardize each of the column vectors of the offset-removed input data (430) to obtain the standardized data (440, 450),
wherein the offset is set for each of the row vectors of the input data (410), and the offset is set as a value of a first entry among the entries of the respective row vectors of the input data (410); or
wherein the processor (150) is further configured to:
smooth the entries of the respective row vectors of the input data (410); and
standardize each of the column vectors of the smoothed input data (420) to obtain the standardized data (440, 450).

2. The electronic device (101, 102) of claim 1, wherein the processor (150) is further configured to:
identify a row vector comprising at least one value less than or equal to a reference threshold standardized score among the row vectors of the determination reference data;
obtain an output vector for the identified row vector based on the learning-based model; and
determine the first state abnormality of a battery cell (111, 113) corresponding to the identified row vector, based on the output vector.

3. The electronic device (101, 102) of claim 1, wherein the processor (150) is further configured to:
obtain a window average value of each of the row vectors of the standardized data (440, 450) as the determination reference data; and
determine the first state abnormality and/or the second state abnormality of each of the M battery cells (111, 113) based on the window average values of the respective row vectors of the determination reference data,
wherein the window average values are average values of the entries of the respective row vectors of the standardized data (440, 450) included in different time windows, and the time windows do not overlap one another.

4. The electronic device (101, 102) of claim 1, wherein the processor (150) is further configured to:
obtain change amounts of the entries of the respective row vectors of the standardized data (440, 450) as the determination reference data; and
determine first state abnormality and/or second state abnormality of each of the M battery cells (111, 113) based on the change amounts of the entries of respective row vectors of the determination reference data.

5. The electronic device (101, 102) of claim 1, wherein the processor (150) is further configured to:
identify a sum of the entries of the respective row vectors of the determination reference data;
identify a row vector corresponding to the sum being less than or equal to a threshold sum value among the row vectors of the determination reference data; and
determine that a battery cell (111, 113) corresponding to the identified row vector has the second state abnormality.

6. The electronic device (101, 102) of claim 1, wherein the learning-based model is an auto encoder, and the auto encoder is trained based on state values of normal battery cells (111, 113).

7. An operating method of an electronic device (101, 102), the operating method comprising:
obtaining input data (410) through a detection circuit of the electronic device (101, 102), wherein the input data (410) is expressible as an M x N matrix, M x N entries of the input data (410) indicate the state values of M respective battery cells (111, 113) of the electronic device (101, 102), and N indicates a number of time periods for obtaining the state values of the M respective battery cells (111, 113);
standardizing each of column vectors of the input data (410) to obtain standardized data (440, 450) for the input data (410), wherein each of the column vectors comprises entries obtained for an identical unit time;
obtaining determination reference data based on the standardized data (440, 450); and
determining first state abnormality and/or second state abnormality of each of the M battery cells (111, 113) based on values indicated by the entries of respective row vectors of the determination reference data,
wherein the first state abnormality is determined based on a learning-based model, and the second state abnormality is determined based on a scheme other than the learning-based model,
wherein the obtaining of the standardized data (440, 450) comprises:
removing an offset from entries of the respective row vectors of the input data (410); and
standardizing each of the column vectors of the offset-removed input data (430) to obtain the standardized data (440, 450),
wherein the offset is set for each of the row vectors of the input data (410), and the offset is set as a value of a first entry among the entries of the respective row vectors of the input data (410); or
wherein the obtaining of the standardized data (440, 450) comprises:
smoothing the entries of the respective row vectors of the input data (410); and
standardizing each of the column vectors of the smoothed input data (420) to obtain the standardized data (440, 450).

8. The operating method of claim 7, wherein the determining of the first state abnormality and/or the second state abnormality comprises:
identifying a row vector comprising at least one value less than or equal to a reference threshold standardized score among the row vectors of the determination reference data;
obtaining an output vector for the identified row vector based on the learning-based model; and
determining the first state abnormality of a battery cell (111, 113) corresponding to the identified row vector, based on the output vector.

9. The operating method of claim 7, wherein the obtaining of the determination reference data comprises obtaining a window average value of each of the row vectors of the standardized data (440, 450) as the determination reference data, and
the determining of the first state abnormality and/or the second state abnormality comprises determining the first state abnormality and/or the second state abnormality of each of the M battery cells (111, 113) based on the window average values of the respective row vectors of the determination reference data,
wherein the window average values are average values of the entries of the respective row vectors of the standardized data (440, 450) included in different time windows, and the time windows do not overlap one another.

10. The operating method of claim 7, wherein the obtaining of the determination reference data comprises obtaining change amounts of the entries of the respective row vectors of the standardized data (440, 450) as the determination reference data, and
the determining of the first state abnormality and/or the second state abnormality comprises determining the first state abnormality and/or the second state abnormality of each of the M battery cells (111, 113) based on the change amounts of the entries of respective row vectors of the determination reference data.

11. The operating method of claim 7, wherein the determining of the first state abnormality and/or the second state abnormality comprises:
identifying a sum of the entries of the respective row vectors of the determination reference data;
identifying a row vector corresponding to the sum being less than or equal to a threshold sum value among the row vectors of the determination reference data; and
determining that a battery cell (111, 113) corresponding to the identified row vector has the second state abnormality.

## Patentansprüche

1. Elektronische Vorrichtung (101, 102), umfassend:
ein Batteriemodul (110), das M Batteriezellen (111, 113) umfasst, wobei M eine ganze Zahl größer oder gleich 2 ist;
eine Erfassungsschaltung, die konfiguriert ist, um Zustandswerte zu erhalten, die sich auf Zustände der M jeweiligen Batteriezellen (111, 113) beziehen; und
einen Prozessor (150),
wobei der Prozessor (150) konfiguriert ist, um:
Eingangsdaten (410) durch die Erfassungsschaltung zu erhalten, wobei die Eingangsdaten (410) als eine M x N Matrix ausdrückbar sind, M x N Einträge der Eingangsdaten (410) die Zustandswerte der M jeweiligen Batteriezellen (111, 113) angeben und N eine Anzahl von Zeitperioden zum Erhalten der Zustandswerte der M jeweiligen Batteriezellen (111, 113) angibt;
jeden der Spaltenvektoren der Eingangsdaten (410) zu standardisieren, um standardisierte Daten (440, 450) für die Eingangsdaten (410) zu erhalten, wobei jeder der Spaltenvektoren Einträge umfasst, die für eine identische Zeiteinheit erhalten werden;
Bestimmungsreferenzdaten basierend auf den standardisierten Daten (440, 450) zu erhalten; und
eine erste Zustandsanomalie und/oder eine zweite Zustandsanomalie jeder der M Batteriezellen (111, 113) basierend auf Werten zu bestimmen, die durch die Einträge der jeweiligen Zeilenvektoren der Bestimmungsreferenzdaten angegeben werden,
wobei die erste Zustandsanomalie basierend auf einem lernbasierten Modell bestimmt wird und die zweite Zustandsanomalie basierend auf einem anderen Schema als dem lernbasierten Modell bestimmt wird,
wobei der Prozessor (150) ferner konfiguriert ist, um:
einen Versatz aus Einträgen der jeweiligen Zeilenvektoren der Eingangsdaten (410) zu entfernen; und
jeden der Spaltenvektoren der versatzentfernten Eingangsdaten (430) zu standardisieren, um die standardisierten Daten (440, 450) zu erhalten,
wobei der Versatz für jeden der Zeilenvektoren der Eingangsdaten (410) eingestellt wird und der Versatz als ein Wert eines ersten Eintrags unter den Einträgen der jeweiligen Zeilenvektoren der Eingangsdaten (410) eingestellt wird; oder
wobei der Prozessor (150) ferner konfiguriert ist, um:
die Einträge der jeweiligen Zeilenvektoren der Eingangsdaten (410) zu glätten; und
jeden der Spaltenvektoren der geglätteten Eingangsdaten (420) zu standardisieren, um die standardisierten Daten (440, 450) zu erhalten.

2. Elektronische Vorrichtung (101, 102) nach Anspruch 1, wobei der Prozessor (150) ferner konfiguriert ist, um:
einen Zeilenvektor zu identifizieren, der mindestens einen Wert umfasst, der kleiner oder gleich einem standardisierten Referenzschwellen-Score unter den Zeilenvektoren der Bestimmungsreferenzdaten ist;
einen Ausgabevektor für den identifizierten Zeilenvektor basierend auf dem lernbasierten Modell zu erhalten; und
die erste Zustandsanomalie einer Batteriezelle (111, 113), die dem identifizierten Zeilenvektor entspricht, basierend auf dem Ausgabevektor zu bestimmen.

3. Elektronische Vorrichtung (101, 102) nach Anspruch 1, wobei der Prozessor (150) ferner konfiguriert ist, um:
einen Fenstermittelwert jedes der Zeilenvektoren der standardisierten Daten (440, 450) als die Bestimmungsreferenzdaten zu erhalten; und
die erste Zustandsanomalie und/oder die zweite Zustandsanomalie jeder der M Batteriezellen (111, 113) basierend auf den Fenstermittelwerten der jeweiligen Zeilenvektoren der Bestimmungsreferenzdaten zu bestimmen,
wobei die Fenstermittelwerte Mittelwerte der Einträge der jeweiligen Zeilenvektoren der standardisierten Daten (440, 450) sind, die in verschiedenen Zeitfenstern enthalten sind, und die Zeitfenster einander nicht überlappen.

4. Elektronische Vorrichtung (101, 102) nach Anspruch 1, wobei der Prozessor (150) ferner konfiguriert ist, um:
Änderungsbeträge der Einträge der jeweiligen Zeilenvektoren der standardisierten Daten (440, 450) als die Bestimmungsreferenzdaten zu erhalten; und
eine erste Zustandsanomalie und/oder eine zweite Zustandsanomalie jeder der M Batteriezellen (111, 113) basierend auf den Änderungsbeträgen der Einträge der jeweiligen Zeilenvektoren der Bestimmungsreferenzdaten zu bestimmen.

5. Elektronische Vorrichtung (101, 102) nach Anspruch 1, wobei der Prozessor (150) ferner konfiguriert ist, um:
eine Summe der Einträge der jeweiligen Zeilenvektoren der Bestimmungsreferenzdaten zu identifizieren;
einen Zeilenvektor zu identifizieren, der der Summe entspricht, die kleiner oder gleich einem Schwellensummenwert unter den Zeilenvektoren der Bestimmungsreferenzdaten ist; und
zu bestimmen, dass eine Batteriezelle (111, 113), die dem identifizierten Zeilenvektor entspricht, die zweite Zustandsanomalie aufweist.

6. Elektronische Vorrichtung (101, 102) nach Anspruch 1, wobei das lernbasierte Modell ein Autocodierer ist und der Autocodierer basierend auf Zustandswerten normaler Batteriezellen (111, 113) trainiert wird.

7. Betriebsverfahren einer elektronischen Vorrichtung (101, 102), wobei das Betriebsverfahren umfasst:
Erhalten von Eingangsdaten (410) durch eine Erfassungsschaltung der elektronischen Vorrichtung (101, 102), wobei die Eingangsdaten (410) als eine M x N Matrix ausdrückbar sind, M x N Einträge der Eingangsdaten (410) die Zustandswerte von M jeweiligen Batteriezellen (111, 113) der elektronischen Vorrichtung (101, 102) angeben und N eine Anzahl von Zeitperioden zum Erhalten der Zustandswerte der M jeweiligen Batteriezellen (111, 113) angibt;
Standardisieren jedes der Spaltenvektoren der Eingangsdaten (410), um standardisierte Daten (440, 450) für die Eingangsdaten (410) zu erhalten, wobei jeder der Spaltenvektoren Einträge umfasst, die für eine identische Zeiteinheit erhalten werden;
Erhalten von Bestimmungsreferenzdaten basierend auf den standardisierten Daten (440, 450); und
Bestimmen einer ersten Zustandsanomalie und/oder einer zweiten Zustandsanomalie jeder der M Batteriezellen (111, 113) basierend auf Werten, die durch die Einträge der jeweiligen Zeilenvektoren der Bestimmungsreferenzdaten angegeben werden,
wobei die erste Zustandsanomalie basierend auf einem lernbasierten Modell bestimmt wird und die zweite Zustandsanomalie basierend auf einem anderen Schema als dem lernbasierten Modell bestimmt wird,
wobei das Erhalten der standardisierten Daten (440, 450) umfasst:
Entfernen eines Versatzes aus Einträgen der jeweiligen Zeilenvektoren der Eingangsdaten (410); und
Standardisieren jedes der Spaltenvektoren der versatzentfernten Eingangsdaten (430), um die standardisierten Daten (440, 450) zu erhalten,
wobei der Versatz für jeden der Zeilenvektoren der Eingangsdaten (410) eingestellt wird und der Versatz als ein Wert eines ersten Eintrags unter den Einträgen der jeweiligen Zeilenvektoren der Eingangsdaten (410) eingestellt wird; oder
wobei das Erhalten der standardisierten Daten (440, 450) umfasst:
Glätten der Einträge der jeweiligen Zeilenvektoren der Eingangsdaten (410); und
Standardisieren jedes der Spaltenvektoren der geglätteten Eingangsdaten (420), um die standardisierten Daten (440, 450) zu erhalten.

8. Betriebsverfahren nach Anspruch 7, wobei das Bestimmen der ersten Zustandsanomalie und/oder der zweiten Zustandsanomalie umfasst:
Identifizieren eines Zeilenvektors, der mindestens einen Wert umfasst, der kleiner oder gleich einem standardisierten Referenzschwellen-Score unter den Zeilenvektoren der Bestimmungsreferenzdaten ist;
Erhalten eines Ausgabevektors für den identifizierten Zeilenvektor basierend auf dem lernbasierten Modell; und
Bestimmen der ersten Zustandsanomalie einer Batteriezelle (111, 113), die dem identifizierten Zeilenvektor entspricht, basierend auf dem Ausgabevektor.

9. Betriebsverfahren nach Anspruch 7, wobei das Erhalten der Bestimmungsreferenzdaten das Erhalten eines Fenstermittelwerts jedes der Zeilenvektoren der standardisierten Daten (440, 450) als die Bestimmungsreferenzdaten umfasst, und
das Bestimmen der ersten Zustandsanomalie und/oder der zweiten Zustandsanomalie das Bestimmen der ersten Zustandsanomalie und/oder der zweiten Zustandsanomalie jeder der M Batteriezellen (111, 113) basierend auf den Fenstermittelwerten der jeweiligen Zeilenvektoren der Bestimmungsreferenzdaten umfasst,
wobei die Fenstermittelwerte Mittelwerte der Einträge der jeweiligen Zeilenvektoren der standardisierten Daten (440, 450) sind, die in verschiedenen Zeitfenstern enthalten sind, und die Zeitfenster einander nicht überlappen.

10. Betriebsverfahren nach Anspruch 7, wobei das Erhalten der Bestimmungsreferenzdaten das Erhalten von Änderungsbeträgen der Einträge der jeweiligen Zeilenvektoren der standardisierten Daten (440, 450) als die Bestimmungsreferenzdaten umfasst, und
das Bestimmen der ersten Zustandsanomalie und/oder der zweiten Zustandsanomalie das Bestimmen der ersten Zustandsanomalie und/oder der zweiten Zustandsanomalie jeder der M Batteriezellen (111, 113) basierend auf den Änderungsbeträgen der Einträge der jeweiligen Zeilenvektoren der Bestimmungsreferenzdaten umfasst.

11. Betriebsverfahren nach Anspruch 7, wobei das Bestimmen der ersten Zustandsanomalie und/oder der zweiten Zustandsanomalie umfasst:
Identifizieren einer Summe der Einträge der jeweiligen Zeilenvektoren der Bestimmungsreferenzdaten;
Identifizieren eines Zeilenvektors, der der Summe entspricht, die kleiner oder gleich einem Schwellensummenwert unter den Zeilenvektoren der Bestimmungsreferenzdaten ist; und
Bestimmen, dass eine Batteriezelle (111, 113), die dem identifizierten Zeilenvektor entspricht, die zweite Zustandsanomalie aufweist.

## Revendications

1. Dispositif électronique (101, 102) comportant :
un module de batterie (110) comportant M éléments de batterie (111, 113), M étant un entier supérieur ou égal à 2 ;
un circuit de détection configuré pour obtenir des valeurs d'état se rapportant aux états des M éléments de batterie respectifs (111, 113) ; et
un processeur (150),
dans lequel le processeur (150) est configuré pour :
obtenir des données d'entrée (410) par le biais du circuit de détection, dans lequel les données d'entrée (410) sont en mesure d'être exprimées sous la forme d'une matrice M x N, M x N entrées des données d'entrée (410) indiquent les valeurs d'état des M éléments de batterie respectifs (111, 113), et N indique un nombre de périodes de temps pour obtenir les valeurs d'état des M éléments de batterie respectifs (111, 113) ;
normaliser chacun des vecteurs colonnes des données d'entrée (410) pour obtenir des données normalisées (440, 450) pour les données d'entrée (410), dans lequel chacun des vecteurs colonnes comporte des entrées obtenues pour une unité de temps identique ;
obtenir des données de référence de détermination sur la base des données normalisées (440, 450) ; et
déterminer un premier état anormal et/ou un deuxième état anormal de chacun des M éléments de batterie (111, 113) sur la base de valeurs indiquées par les entrées des vecteurs lignes respectifs des données de référence de détermination,
dans lequel le premier état anormal est déterminé sur la base d'un modèle basé sur l'apprentissage, et le deuxième état anormal est déterminé sur la base d'un système autre que le modèle basé sur l'apprentissage,
dans lequel le processeur (150) est par ailleurs configuré pour :
supprimer un décalage dans les entrées des vecteurs lignes respectifs des données d'entrée (410) ; et
normaliser chacun des vecteurs colonnes des données d'entrée (430) dont le décalage a été supprimé pour obtenir les données normalisées (440, 450),
dans lequel le décalage est établi pour chacun des vecteurs lignes des données d'entrée (410), et le décalage est établi en tant que valeur d'une première entrée parmi les entrées des vecteurs lignes respectifs des données d'entrée (410) ; ou
dans lequel le processeur (150) est par ailleurs configuré pour :
lisser les entrées des vecteurs lignes respectifs des données d'entrée (410) ; et
normaliser chacun des vecteurs colonnes des données d'entrée lissées (420) pour obtenir les données normalisées (440, 450).

2. Dispositif électronique (101, 102) selon la revendication 1, dans lequel le processeur (150) est par ailleurs configuré pour :
identifier un vecteur ligne comportant au moins une valeur inférieure ou égale à un score normalisé de seuil de référence parmi les vecteurs lignes des données de référence de détermination ;
obtenir un vecteur de sortie pour le vecteur ligne identifié sur la base du modèle basé sur l'apprentissage ; et
déterminer le premier état anormal d'un élément de batterie (111, 113) correspondant au vecteur ligne identifié, sur la base du vecteur de sortie.

3. Dispositif électronique (101, 102) selon la revendication 1, dans lequel le processeur (150) est par ailleurs configuré pour :
obtenir une valeur moyenne de fenêtre de chacun des vecteurs lignes des données normalisées (440, 450) en tant que données de référence de détermination ; et
déterminer le premier état anormal et/ou le deuxième état anormal de chacun des M éléments de batterie (111, 113) sur la base des valeurs moyennes de fenêtre des vecteurs lignes respectifs des données de référence de détermination,
dans lequel les valeurs moyennes de fenêtre sont des valeurs moyennes des entrées des vecteurs lignes respectifs des données normalisées (440, 450) incluses dans différentes fenêtres de temps, et les fenêtres de temps ne se chevauchent pas les unes les autres.

4. Dispositif électronique (101, 102) selon la revendication 1, dans lequel le processeur (150) est par ailleurs configuré pour :
obtenir des quantités de changement des entrées des vecteurs lignes respectifs des données normalisées (440, 450) en tant que données de référence de détermination ; et
déterminer un premier état anormal et/ou un deuxième état anormal de chacun des M éléments de batterie (111, 113) sur la base des quantités de changement des entrées des vecteurs lignes respectifs des données de référence de détermination.

5. Dispositif électronique (101, 102) selon la revendication 1, dans lequel le processeur (150) est par ailleurs configuré pour :
identifier une somme des entrées des vecteurs lignes respectifs des données de référence de détermination ;
identifier un vecteur ligne correspondant à la somme qui est inférieure ou égale à une valeur de somme de seuil parmi les vecteurs lignes des données de référence de détermination ; et
déterminer comme quoi un élément de batterie (111, 113) correspondant au vecteur ligne identifié présente le deuxième état anormal.

6. Dispositif électronique (101, 102) selon la revendication 1, dans lequel le modèle basé sur l'apprentissage est un autoencodeur, et l'autoencodeur est entraîné sur la base de valeurs d'état d'éléments de batterie normaux (111, 113).

7. Procédé de fonctionnement d'un dispositif électronique (101, 102), le procédé de fonctionnement comportant les étapes consistant à :
obtenir des données d'entrée (410) par le biais d'un circuit de détection du dispositif électronique (101, 102), dans lequel les données d'entrée (410) sont en mesure d'être exprimées sous la forme d'une matrice M x N, M x N entrées des données d'entrée (410) indiquent les valeurs d'état de M éléments de batterie respectifs (111, 113) du dispositif électronique (101, 102), et N indique un nombre de périodes de temps pour obtenir les valeurs d'état des M éléments de batterie respectifs (111, 113) ;
normaliser chacun des vecteurs colonnes des données d'entrée (410) pour obtenir des données normalisées (440, 450) pour les données d'entrée (410), dans lequel chacun des vecteurs colonnes comporte des entrées obtenues pour une unité de temps identique ;
obtenir des données de référence de détermination sur la base des données normalisées (440, 450) ; et
déterminer un premier état anormal et/ou un deuxième état anormal de chacun des M éléments de batterie (111, 113) sur la base de valeurs indiquées par les entrées de vecteurs lignes respectifs des données de référence de détermination,
dans lequel le premier état anormal est déterminé sur la base d'un modèle basé sur l'apprentissage, et le deuxième état anormal est déterminé sur la base d'un système autre que le modèle basé sur l'apprentissage,
dans lequel l'étape consistant à obtenir les données normalisées (440, 450) comporte les étapes consistant à :
supprimer un décalage dans les entrées des vecteurs lignes respectifs des données d'entrée (410) ; et
normaliser chacun des vecteurs colonnes des données d'entrée (430) dont le décalage a été supprimé pour obtenir les données normalisées (440, 450),
dans lequel le décalage est établi pour chacun des vecteurs lignes des données d'entrée (410), et le décalage est établi en tant que valeur d'une première entrée parmi les entrées des vecteurs lignes respectifs des données d'entrée (410) ; ou
dans lequel l'étape consistant à obtenir les données normalisées (440, 450) comporte les étapes consistant à :
lisser les entrées des vecteurs lignes respectifs des données d'entrée (410) ; et
normaliser chacun des vecteurs colonnes des données d'entrée lissées (420) pour obtenir les données normalisées (440, 450).

8. Procédé de fonctionnement selon la revendication 7, dans lequel l'étape consistant à déterminer le premier état anormal et/ou le deuxième état anormal comporte les étapes consistant à :
identifier un vecteur ligne comportant au moins une valeur inférieure ou égale à un score normalisé de seuil de référence parmi les vecteurs lignes des données de référence de détermination ;
obtenir un vecteur de sortie pour le vecteur ligne identifié sur la base du modèle basé sur l'apprentissage ; et
déterminer le premier état anormal d'un élément de batterie (111, 113) correspondant au vecteur ligne identifié, sur la base du vecteur de sortie.

9. Procédé de fonctionnement selon la revendication 7, dans lequel l'étape consistant à obtenir les données de référence de détermination comporte l'étape consistant à obtenir une valeur moyenne de fenêtre de chacun des vecteurs lignes des données normalisées (440, 450) en tant que données de référence de détermination, et
l'étape consistant à déterminer le premier état anormal et/ou le deuxième état anormal comporte l'étape consistant à déterminer le premier état anormal et/ou le deuxième état anormal de chacun des M éléments de batterie (111, 113) sur la base des valeurs moyennes de fenêtre des vecteurs lignes respectifs des données de référence de détermination,
dans lequel les valeurs moyennes de fenêtre sont des valeurs moyennes des entrées des vecteurs lignes respectifs des données normalisées (440, 450) incluses dans différentes fenêtres de temps, et les fenêtres de temps ne se chevauchent pas les unes les autres.

10. Procédé de fonctionnement selon la revendication 7, dans lequel l'étape consistant à obtenir les données de référence de détermination comporte l'étape consistant à obtenir des quantités de changement des entrées des vecteurs lignes respectifs des données normalisées (440, 450) en tant que données de référence de détermination, et
l'étape consistant à déterminer le premier état anormal et/ou le deuxième état anormal comporte l'étape consistant à déterminer le premier état anormal et/ou le deuxième état anormal de chacun des M éléments de batterie (111, 113) sur la base des quantités de changement des entrées des vecteurs lignes respectifs des données de référence de détermination.

11. Procédé de fonctionnement selon la revendication 7, dans lequel l'étape consistant à déterminer le premier état anormal et/ou le deuxième état anormal comporte les étapes consistant à :
identifier une somme des entrées des vecteurs lignes respectifs des données de référence de détermination ;
identifier un vecteur ligne correspondant à la somme qui est inférieure ou égale à une valeur de somme de seuil parmi les vecteurs lignes des données de référence de détermination ; et
déterminer comme quoi un élément de batterie (111, 113) correspondant au vecteur ligne identifié présente le deuxième état anormal.
